# EUROPÄISCHE PATENTANMELDUNG

(11) **EP 3 588 071 A1**
(43) Veröffentlichungstag der Anmeldung: **01.01.2020**
(21) Anmeldenummer: 19172286.7
(22) Anmeldetag: 02.05.2019
(51) Int. Cl.: G01N 27/07, G01R 27/22

(54) **SENSOR ZUM DETEKTIEREN VON IONEN IN EINEM FLUID SOWIE VERFAHREN ZUM DETEKTIEREN VON IONEN IN EINEM FLUID MIT EINEM SOLCHEN SENSOR**

(30) Priorität: 27.06.2018 DE 102018210484
(71) Anmelder: Robert Bosch GmbH, 70442 Stuttgart (DE)
(72) Erfinder: Widmaier, Mathias, 71106 Magstadt (DE); Bommer, Lars, 71229 Leonberg (DE)

(57) **Zusammenfassung**

Die Erfindung geht aus von einem Sensor (10) zum Detektieren von Ionen (12, 14, 16) in einem Fluid (22) mit einer oder mehreren Elektroden (24 bis 42), an die eine Spannung anlegbar und ein Strom zwischen den Elektroden (24 bis 42) messbar ist. Es wird vorgeschlagen, dass
die Elektrode (24 bis 42) oder die Elektroden (24 bis 42) jeweils eine Porenstruktur (54) aufweisen, die mit zu bestimmenden Ionen (12, 14, 16) im Fluid (22) in eine Wechselwirkung tritt. Die Erfindung betrifft auch ein Verfahren unter Benutzung eines solchen Sensors (10) wobei das Fluid (22) einem elektrischen Feld ausgesetzt wird, dass zwischen verschiedenen Elektroden (24 bis 42) eine Spannung angelegt wird, dass der sich einstellende Strom oder die sich einstellenden Ströme erfasst werden, dass der erfasste Strom oder die erfassten Ströme mit in einem Speicher hinterlegten, bestimmten Ionen (12, 14, 16) zugeordneten Stromwerten und/oder Stromverlaufsmuster verglichen werden und dass die mittels der Stromwerte und/oder Stromverlaufsmuster ermittelnden Ionen (12, 14, 16) abgespeichert und/oder ausgegeben werden.

## Beschreibung

Die Erfindung betrifft einen Sensor zum Detektieren von Ionen in einem Fluid mit einer oder mehreren Elektroden, an die eine Spannung anlegbar und zwischen denen ein Strom messbar ist. Die Erfindung betrifft auch ein Verfahren zum Detektieren von Ionen in einem Fluid, insbesondere mit einem solchen Sensor, wobei das Fluid einem elektrischen Feld ausgesetzt wird.

### Stand der Technik

Mit der WO 2016/145415 A1 ist ein Verfahren und eine Einrichtung bekannt geworden, mit der Moleküle detektiert werden können. Dazu wird vorgeschlagen, einen Arbeitsraum über eine, Nanoporen aufweisende Membran aufzuteilen, eine Spannung anzulegen und die Moleküle durch die Membran zu bewegen. Dadurch ergibt sich eine messbare Änderung beim Durchgang durch die Membran. Dieses Verfahren lässt sich direkt für größere Moleküle anwenden und es wird ein Procedere für eine indirekte Messmethode für kleinere Moleküle aufgezeigt. Nachteilig daran sind der komplexe Aufbau sowie die beschränkte Anwendung auf Moleküle.

### Offenbarung der Erfindung

### Vorteile der Erfindung

Der erfindungsgemäße Sensor mit den Merkmalen des Hauptanspruchs zeichnet sich dadurch aus, dass die Elektrode oder die Elektroden jeweils eine Porenstruktur aufweisen, die mit zu bestimmenden Ionen im Fluid in Wechselwirkung treten.

Unter einer Porenstruktur wird eine Struktur verstanden, die an der Oberfläche der Elektroden Öffnungen aufweist, wobei sich die Öffnungen in den Körper der Elektrode hinein bzw. hindurch erstrecken können. Die Poren können von runder, unrunder, kugeliger, kanalförmiger oder ähnlicher Gestalt sein.

Unter der Bezeichnung "in Wechselwirkung treten" wird verstanden, dass sich die zu detektierenden Ionen in oder an die Poren anlagern und das elektrische Feld und/oder den Stromfluss im Bereich der Poren messbar beeinflussen.

Der Erfindung liegt die Erkenntnis zugrunde, dass verschiedene lonenspezies mit dem porösen Material mit definierter Porenstruktur und Porengröße in unterschiedliche, spezifische Wechselwirkungen treten. Diese beruhen auf einer elektrostatischen Ladungsspeicherung durch Ausbildung einer elektrochemischen Doppelschicht an der Elektrolyt-Kohlenstoffgrenzfläche. Die elektrochemische Doppelschicht setzt sich zusammen aus elektrisch geladenen Kohlenstoffwänden und darauf absorbierten Ionen mit gegensätzlicher Ladung. Die Kapazität, und damit der Stromfluss in Abhängigkeit der Zeit, ist dabei stark abhängig vom Verhältnis Porengröße/Ionenradius. Zusätzlich zeigen unterschiedliche Ionen unterschiedliches kinetisches Verhalten, welches ebenfalls stark von der Porengröße des Kohlenstoffes beeinflusst wird. Somit können einzelne lonenspezies detektiert und, wenn mehrere Elektroden eingesetzt werden, auch unterschieden werden.

Durch die in den Unteransprüchen aufgeführten Merkmale sind vorteilhafte Weiterbildungen des Sensors nach dem Hauptanspruch möglich. So kann der Sensor einen Speicher aufweisen, in dem im Labor gemessene, ionenspezifische Stromwerte und/oder Strommuster abgelegt sind. Ein Vergleich des Messergebnisses mit den abgelegten Stromwerten bzw. Strommuster lässt dann Rückschlüsse auf die gemessenen lonenspezies zu.

In vorteilhafter Weise weisen die Poren der Porenstruktur einen mittleren Durchmesser im Nanobereich auf. Dabei soll unter mittlerem Durchmesser verstanden werden, dass herstellungsbedingte Toleranzen, die zu einer Variation der Durchmesser führen können, gemittelt werden. Bei unrunden Poren wird unter dem mittleren Durchmesser der Durchmesser verstanden, der mit den zu detektierenden Ionen in Wechselwirkung treten kann. Unter Nanobereich ist eine Größe im Bereich von einem oder mehreren Nanometer zu verstehen.

In einem bevorzugten Ausführungsbeispiel liegt der mittlere Durchmesser zwischen 0,2 und 50nm, sodass gewährleistet ist, dass neben sehr kleinen Ionen auch größere Ionen in Wechselwirkung treten können. Ist mit gleichartigen, nicht allzu großen Ionen zu rechnen oder sollen nur kleine Ionen detektiert werden, hat sich ein Bereich zwischen 0,3 und 20nm als effektiv herausgestellt.

Sind unterschiedliche Elektroden mit unterschiedlicher Porenstruktur vorgesehen, können unterschiedliche Ionen gleichzeitig oder nacheinander detektiert oder auch in ihrer Konzentration bestimmt werden.

Als Material für die Porenstruktur hat sich Aktivkohle oder CDC (carbid derived carbon) als sehr vorteilhaft herausgestellt.

Um gleichzeitig mehrere unterschiedliche Ionen zu detektieren, können Elektroden mit unterschiedlicher Porenstruktur zueinander parallelgeschaltet sein. Sie können auch einzeln oder in Gruppen von Elektroden zueinander in Reihe geschaltet sein. Letztendlich werden Stromwerte und/oder Stromverlaufsmuster gemessen und ausgewertet.

Die Erfindung betrifft auch ein Verfahren zum Detektieren von Ionen in einem Fluid mit einem Sensor, wobei das Fluid einem elektrischen Feld ausgesetzt wird. Das erfindungsgemäße Verfahren ist dadurch gekennzeichnet, dass zwischen verschiedenen Elektroden eine Spannung angelegt wird, dass der sich einstellende Strom oder die sich einstellenden Ströme erfasst werden, dass der erfasste Strom oder die erfassten Ströme mit in einem Speicher hinterlegten, bestimmten Ionen zugeordneten Stromwerten und/oder Stromverlaufsmuster verglichen werden und dass die mittels der Stomwerte und/oder Stromverlaufsmuster ermittelnden Ionen abgespeichert und/oder ausgegeben werden. Auf diese Weise kann die Qualität oder Belastung eines Fluids einmalig oder kontinuierlich bestimmt und ausgewertet werden.

Wird während der Detektion die Spannung variiert, verbessert sich die Qualität der Messung. Es ist dann auch möglich Konzentrationen von bestimmten Ionen im Fluid zu bestimmen. Hierbei kann die der Spannungsänderung direkt oder zeitlich versetzte zugeordnete Stromänderung ausgewertet werden.

Die Qualität der Detektion kann weiter erhöht werden, wenn die Spannung rampenförmig, d.h. von einem niederen auf einen hohen Wert oder umgekehrt, verläuft. Eine Art kontinuierliche, sich wiederholende Rampe kann erzeugt werden, indem eine sinusförmige Spannung angelegt wird. Mittels einer gepulsten Spannung können zeitlich getrennte Bestimmungen vorgenommen werden. Es ist prinzipiell auch möglich eine Frequenzanalyse ausgehend von der gepulsten Spannung anzufertigen und die lonenspezies darüber zu detektieren.

### Zeichnung

In der Zeichnung sind Ausführungsbeispiele erfindungsgemäße Sensoren sowie ein Verfahren dargestellt und in der nachfolgenden Beschreibung näher erläutert. Es zeigen:
Figur 1 einen erfindungsgemäßen Sensor in mehreren Ausbaustufen,
Figur 2 ein Flussdiagramm eines erfindungsgemäßen Verfahrens und
Figur 3 eine mögliche Porenstruktur.

### Beschreibung

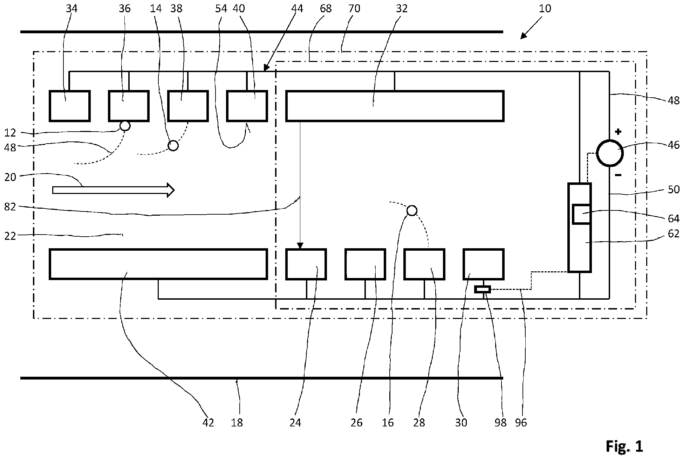

In Figur 1 ist ein Sensor 10 zum Detektieren von Ionen 12, 14, 16 dargestellt. Der Sensor 10 ist in einer Leitung 18 angeordnet, wobei in Figur 1 der Sensor 10 nur schematisch und übergroß dargestellt ist. In der Regel sind die Sensoren 10 gegenüber der Leitung 18 bedeutend kleiner, sodass sie den Fluss (angedeutet durch den Pfeil 20) eines Fluid 22 möglichst wenig stören.

Im Ausführungsbeispiel weist der Sensor 10 eine Reihe von ersten Elektroden 24 bis 30 auf, denen eine erste Gegenelektrode 32 gegenüberliegt. Ferner weist der Sensor 10 im Ausführungsbeispiel eine Reihe von zweiten Elektroden 34 bis 40 auf, denen eine zweite Gegenelektrode 42 gegenüberliegt.

Die Elektroden 24 bis 42 sind Teil eines Schaltkreises 44. Der Schaltkreis 44 weist eine Spannungsquelle 46 auf, die über Leitungen 48, 50 mit den Elektroden 24 bis 42 verbunden ist. Dabei sind die ersten Elektroden 24 bis 30 gegenüber der ersten Gegenelektrode 32 auf unterschiedlichem Spannungspotenzial. Die zweiten Elektroden 34 bis 40 sind gegenüber der zweiten Gegenelektrode 42 ebenfalls auf unterschiedlichem Spannungspotenzial.

Im Ausführungsbeispiel liegen die ersten Elektroden 24 bis 30 und die zweite Gegenelektrode 42 auf negativem Potenzial während die erste Gegenelektrode 32 und die zweiten Elektroden 34 bis 40 auf positiven Potenzial liegen.

In einem Fluid 22 wie Wasser liegen salzige Substanzen in dissoziierter Form, also als Ionen, vor. Im Fluid 22 können sowohl positive Ionen 12, 16, wie Natrium (Na⁺), Magnesium (Mg⁺⁺) oder Calcium (Ca⁺⁺), als auch negative Ionen 14 wie Chlor (Cl⁻), Schwefelsulfat (SO₄²⁻) oder Carbonat (CO₃²⁻), vorkommen. Die Ionen können dabei atomar als auch molekular auftreten.

In dem durch die Elektroden 24 bis 42 aufgespannt elektrischen Feld bewegen sich die Ionen entsprechend ihrer Ladung auf die entsprechend gegengeladenen Elektroden zu. Fließt das Fluid 22, wie durch den Pfeil 20 angedeutet, bewegen sich die Ionen auf gebogenen Bahnen 52. Treffen die Ionen auf die Elektroden ist ein Stromfluss feststellbar.

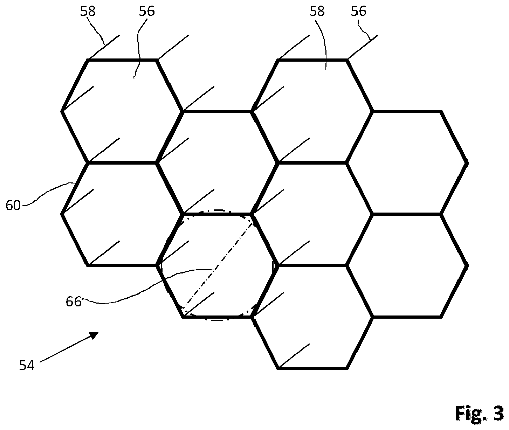

Die ersten Elektroden 24 bis 30 sowie die zweiten Elektroden 34 bis 40 weisen eine Porenstruktur 54 auf, wie sie beispielhaft in Figur 3 dargestellt ist. In Figur 3 sind einzelne Poren 56 der Porenstruktur 54 als Kanäle 58 mit einem 6-eckigen Querschnitt 60 dargestellt. Diese Poren 60 treten mit den Ionen 12 bis 16 in eine Wechselwirkung. Dazu lagern sich die Ionen an der Porenstruktur 54 an. Die Porenstruktur 54 ist dazu so ausgebildet, dass sie genau mit der zu bestimmenden lonenspezies optimal in eine Wechselwirkung eintritt.

Der durch die an die Porenstruktur 54 ein- oder angelagerten Ionen ausgelöste Strom wird von einer Steuereinheit 62 erfasst. Dieser Strom, dessen Wert oder dessen Stromverlaufsmuster ist charakteristisch für eine bestimmte lonenart. Auf diese Weise kann also eine lonenart im Fluid nachgewiesen werden.

Um den Nachweis eindeutig zu führen, weist die Steuereinheit 62 einen Speicher 64 auf, in dem eine Vielzahl von Stromwerten und/oder Stromverlaufsmuster abgelegt sind. Über einen Vergleich der erfassten Ströme bzw. Stromverlaufsmuster mit den im Speicher 64 abgelegten Ströme bzw. Stromverlaufsmuster gelingt es, die mit der Porenstruktur 54 in Wechselwirkung getretenen Ionen zu bestimmen. Die im Speicher abgelegten Stromwerte und/oder Stromverlaufsmuster sind im Vorfeld unter Laborbedingungen empirisch ermittelt und im Speicher abgelegt worden.

Um die optimale Porenstruktur 54 als auch die Stromwerte und/oder Stromverlaufsmuster zu ermitteln werden in Versuchsreihen Elektroden mit unterschiedlichen Porenstrukturen 54 vorbereitet. Die Porenstrukturen 54 weisen dabei Poren 56 mit unterschiedlicher Größe und unterschiedlichem Querschnitt auf. Diese werden in ein strömendes Fluid 22 eingebracht und eine definierte, bevorzugt variierende Spannung an die Elektroden und die Gegenelektrode angelegt. Das Fluid 22 weist bevorzugt eine einzelne hochkonzentrierte lonensorte auf, die dann vermessen wird. Je Elektrode wird der Stromwert bzw. das Stromverlaufsmuster aufgenommen und dasjenige, das am charakteristischen für diese lonenspezies ist, im Speicher 64 abgelegt. Dies wird mit Fluid 22 mit unterschiedlichen lonenspezies durchgeführt, sodass sich im Speicher 64 eine Vielzahl von Stromwerten und/oder Stromverlaufsmuster befinden.

Die erste und zweite Gegenelektroden 32 und 42 weisen eine Porenstruktur 54 auf, die so beschaffen ist, dass möglichst viele lonenspezies mit ihr in Wechselwirkung treten. Dadurch entsteht ein gemittelter Stromverlauf, der den an den spezifizierten ersten und zweiten Elektroden entstehenden Stromverlauf möglichst wenig beeinflusst. Es ist auch möglich, die Gegenelektroden 32 und 42 ohne Porenstruktur bereitzustellen.

Die ersten und zweiten Elektroden 24 bis 30 und 34 bis 40 weisen eine Porenstruktur 54 mit Poren 56 mit einem mittleren Durchmesser 66 im Nanobereich auf. D.h., der mittlere Durchmesser liegt zwischen 0,2nm und 50nm. Damit können die meisten gängigen Ionen im Fluid 22 detektiert werden. Ist daran gelegen nur kleine Ionen, wie beispielsweise Metallionen, zu detektieren, wird man eine Porenstruktur 54 mit Poren mit einem mittleren Durchmesser 66 zwischen 0,2nm und 20nm wählen.

In Figur 3 ist ein mittlerer Durchmesser 66 für eine 6-eckige Porenstruktur 54 eingezeichnet.

Im Ausführungsbeispiel sind jeweils vier erste Elektroden 24 bis 30 und vier zweite Elektroden 34 bis 40 vorgesehen, wobei die Elektroden mit unterschiedlicher Porenstruktur 54 ausgestattet sind. Jede Elektrode ist auf eine oder zwei lonenspezies ausgerichtet. Auf diese Weise können mindestens acht unterschiedliche Ionen detektiert werden. Es ist jedoch auch möglich mehr oder weniger Elektroden vorzusehen. In Figur 1 ist mit der strichpunktierten Linie 68 ein erster Sensortyp dargestellt, bei dem lediglich einer Gegenelektrode 32 vier spezifizierten Elektroden 24 bis 30 gegenüberstehen. Hier werden jeweils nur die positiven oder nur die negativen Ionen gemessen, es sei denn es wird die Spannung während der Messung umgepolt. Mit der strichpunktierten Linie 70 ist ein Sensortyp dargestellt, bei dem ein solches Umpolen nicht notwendig ist. Hier gibt es eine Gegenelektrode 32 für den negativen Spannungsanteil und eine Gegenelektrode 42 für den positiven Spannungsanteil. Denen stehen jeweils die spezifizierten Einzelelektroden24 bis 30 bzw. 34 bis 40 gegenüber.

Im Ausführungsbeispiel wird die Porenstruktur über einen sogenannten CDC (carbid derived carbon) bereitgestellt. Mit dieser inzwischen auch großtechnisch herstellbaren Kohlenstoffstruktur können unterschiedliche Porenquerschnitte und Porengrößen erzeugt werden. Im Ausführungsbeispiel besteht die Oberfläche der Elektroden aus CDC, während der Kern eine Metallplatte enthält. Dadurch ist eine gewisse Festigkeit gewährleistet. Natürlich ist es auch möglich, die Elektroden vollständig aus CDC bereitzustellen. Insbesondere für die Gegenelektroden aber auch für Elektroden für bestimmte Ionen kann als Ausgangsmaterial auch Aktivkohle verwendet werden.

Die Elektroden 24 bis 30 sind zueinander über die Leitung 50 parallel geschaltet. Ihnen gegenüber liegt die Gegenelektrode 32, die an die Leitung 48 angeschlossen ist. Auch die Elektroden 34 bis 40 sind zueinander parallel geschaltet und liegen der Gegenelektrode 42 gegenüber. Durch diese Parallelschaltung werden einzelne Strombeiträge auf die Leitungen 48 bzw. 50 gelegt und können so durch die Steuereinheit 62 ausgewertet werden.

Die Elektroden könnten prinzipiell auch in Reihe geschaltet werden. Dazu wäre dann beispielsweise die Leitung 50 durch die Elektroden 24 bis 30 durchgeführt. Die Gruppe der Elektroden 24 bis 30 könnte dann zur Gegenelektrode 42 parallel oder mit dieser ebenfalls in Reihe geschaltet sein.

Je nach Einsatzzweck kann der Sensor auch mit einem Akkumulator bestückt sein und somit autark arbeiten oder mobil eingesetzt werden.

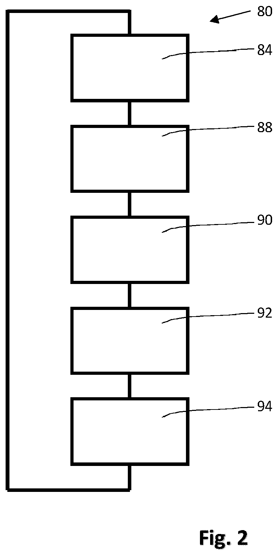

In Figur 2 ist ein Verfahren 80 zum Detektieren von Ionen 12 bis 16 in einem Fluid 22 dargestellt. Im Ausführungsbeispiel wird bei diesem Verfahren 80 ein Sensor 10 nach dem ersten Ausführungsbeispiel eingesetzt. Dabei wird das Fluid 22 einem elektrischen Feld, in Figur 1 angedeutet durch die Feldlinie 82, ausgesetzt. Dazu wird in einem ersten Schritt 84 zwischen den verschiedenen Elektroden 24 bis 30 und 42 einerseits sowie 32 bis 40 andererseits eine Spannung angelegt. Dies geschieht ausgehend von der Steuereinheit 62, die über eine Leitung oder ein Bussystem 86 auf die Spannungsquelle 46 einwirkt.

Durch das elektrische Feld werden in dem Fluid 22 vorliegende Ionen 12 bis 16 entsprechend ihrer Ladung auf die Elektroden zubewegt. Die Ionen 12 bis 16 treffen auf die Oberflächen der Elektroden und treten mit diesen Wechselwirkungen. Durch die vorbestimmte, unterschiedliche Porenstruktur 54 der Elektroden lagern sich die Ionen an den Elektroden an, deren Porenstruktur 54 die Wechselwirkung begünstigt. Bevorzugt lagert sich dabei an jeder Elektrode nur eine besondere lonenspezies an. Dies ist aber Toleranz behaftet und kann nicht immer sicher eingehalten werden.

Durch die Anlagerung der Ionen 12 bis 16 entsteht ein Stromfluss im Schaltkreis 44, der von der Steuereinheit 62 in einem Schritt 88 erfasst und dann ausgewertet wird. Je nachdem welche Ionen sich in welcher Konzentration an den ihnen vorbestimmten Elektroden anlagern, entsteht ein charakteristischer Stromwert oder ein charakteristisches Stromverlaufsmuster. Der erfasste Strom wird in einem Schritt 90 mit in den Speicher 64 hinterlegten, bestimmten Ionen zugeordneten Stromwerten bzw. Stromverlaufsmuster verglichen. Die erkannten Ionen werden dann in einem Schritt 92 abgespeichert und im Ausführungsbeispiel in einem Schritt 94 über eine nicht dargestellte Leitung oder ein Bussystem ausgegeben. Diese Ausgabe kann natürlich auch leitungslos erfolgen.

In der Figur 1 ist angedeutet, dass die Steuereinheit 62 über eine Leitung 96 auf einen Schalter 98 einwirken kann. Mit diesem Schalter 98 kann dann eine Elektrode 30 zugeschaltet oder abgetrennt werden. Dieser Schalter 98 ist beispielhaft für die Elektrode 30 gezeichnet, kann sich jedoch auf alle Elektroden erstrecken. Durch diese Mimik ist es möglich, jeweils einzelne Elektroden gesondert auszuwerten. Dies kann dann wichtig sein, wenn es darum geht eine besondere lonenspezies zu detektieren. Das Verfahren 80 würde dann für die einzelnen lonenspezies gesondert durchfahren werden.

Das Anlegen der Spannung im Schnitt 84 kann beinhalten, dass die Spannung während der Detektion variiert wird. Dazu wirkt die Steuereinheit 62 auf die Spannungsquelle 46 entsprechend ein. Die Variation der Spannung kann rampenförmig sein. Wird die Rampe kontinuierlich wiederholt, entsteht eine Sägezahnspannung. Diese kann durch eine sinusförmige Spannung ersetzt sein.

Wirkt die Steuereinheit 62 auf die Spannungsquelle 46 der Art ein, dass eine gepulste Spannung entsteht, können diese einzelnen Impulse zu entsprechenden Stromwerten bzw. Stromverlaufsmuster führen, die dann einzeln ausgewertet werden können. Die Spannungsimpulse können beispielsweise mit dem Zu- und Abschalten einzelner Elektroden synchronisiert sein. Durch einen gepulsten Betrieb wird die Energieaufnahme verringert. Außerdem wird die unterschiedliche Kinematik unterschiedlich schwerer Ionen ausgenutzt, die sich so eindeutiger Detektieren lassen.

Zur Regeneration des Sensors 10 wird in einem hier nicht dargestellten Verfahrensschritt die Spannung umgepolt, sodass sich die angelagerten Ionen von den Elektroden wieder entfernen. Hier ist es möglich und sinnvoll mit einem höheren Spannungsniveau zu arbeiten oder auch eine stark gepulste Spannung einzusetzen.

Solche Sensoren finden unter anderem beim Bestimmen des Salzgehalts im Brauchwasser ihr Anwendung. Dort werden lonentauscher eingesetzt, um eine Verkalkung zu verhindern. Mit dem Sensor kann die lonenzusammensetzung im Wasser ermittelt werden, um dann den lonentauscher optimal betreiben zu können. Alternative Anwendungen finden sich bei der Detektion von Metallgehalten in Flüssigkeiten, wie zum Beispiel Eisen, Uran oder dergleichen.

Die Elektroden 24 bis 42 sind in zwei parallelen Reihen in Serie hintereinander angeordnet. Je nach Platzverhältnis und Strömungseigenschaften können die Elektroden auch dem Fluss des Fluids nebeneinander entgegengestellt werden.

## Patentansprüche

1. Sensor (10) zum Detektieren von Ionen (12, 14, 16) in einem Fluid (22) mit einer oder mehreren Elektroden (24 bis 42), an die eine Spannung anlegbar und ein Strom zwischen den Elektroden (24 bis 42) messbar ist,
**dadurch gekennzeichnet, dass**
die Elektrode (24 bis 42) oder die Elektroden (24 bis 42) jeweils eine Porenstruktur (54) aufweisen, die mit zu bestimmenden Ionen (12, 14, 16) im Fluid (22) in eine Wechselwirkung tritt.

2. Sensor (10) nach Anspruch 1, **dadurch gekennzeichnet, dass** die Porenstruktur (54) empirisch ermittelt und vordefinierten Spannungen ausgesetzt wird und die gemessenen Stromwerte und/oder Stromverlaufsmuster in einem Speicher (64) abgelegt sind.

3. Sensor (10) nach einem der vorhergehenden Ansprüche, **dadurch gekennzeichnet, dass** die Porenstruktur (54) Poren (56) mit einem mittleren Durchmesser (66) im Nanobereich, insbesondere zwischen 0,2 und 50nm, vorzugsweise zwischen 0,3 und 20nm, aufweist.

4. Sensor (10) nach einem der vorhergehenden Ansprüche, **gekennzeichnet durch** unterschiedliche Elektroden (24 bis 42) mit unterschiedlicher Porenstruktur (54).

5. Sensor (10) nach einem der vorhergehenden Ansprüche, **dadurch gekennzeichnet, dass** die Porenstruktur (54) aus Aktivkohle und/oder CDC (carbit derived carbon) besteht oder diese zumindest enthalten.

6. Sensor (10) nach einem der vorhergehenden Ansprüche, **dadurch gekennzeichnet, dass** mehrere Elektroden (24 bis 42) mit unterschiedlichen Porenstrukturen (54) zueinander parallelgeschaltet sind.

7. Sensor (10) nach einem der vorhergehenden Ansprüche, **dadurch gekennzeichnet, dass** Elektroden (24 bis 42) oder Gruppen von Elektroden (24 bis 42) zueinander in Reihe geschaltet sind.

8. Verfahren zum Detektieren von Ionen (12, 14, 16) in einem Fluid (22) mit einem Sensor (10), insbesondere nach einem der vorhergehenden Ansprüche, wobei das Fluid (22) einem elektrischen Feld ausgesetzt wird, **dadurch gekennzeichnet, dass** zwischen verschiedenen Elektroden (24 bis 42) eine Spannung angelegt wird, dass der sich einstellende Strom oder die sich einstellenden Ströme erfasst werden, dass der erfasste Strom oder die erfassten Ströme mit in einem Speicher hinterlegten, bestimmten Ionen (12, 14, 16) zugeordneten Stromwerten und/oder Stromverlaufsmuster verglichen werden und dass die mittels der Stromwerte und/oder Stromverlaufsmuster ermittelnden Ionen (12, 14, 16) abgespeichert und/oder ausgegeben werden.

9. Verfahren nach Anspruch 8, **dadurch gekennzeichnet, dass** die Spannung während der Detektion variiert wird.

10. Verfahren nach einem der Ansprüche 8 oder 9, **dadurch gekennzeichnet, dass** die Spannung rampenförmig und/oder sinusförmig und/oder gepulst angelegt wird.
